**Europäisches Patentamt**

**European Patent Office**

**Office européen des brevets**

(19)

(11) Veröffentlichungsnummer: **0 271 703 B1**

# EUROPÄISCHE PATENTSCHRIFT

(45) Veröffentlichungstag der Patentschrift: **08.05.91**

(51) Int. Cl.⁵: $H03C\ 1/06$

(21) Anmeldenummer: **87116364.8**

(22) Anmeldetag: **06.11.87**

(54) **Amplitudenmodulierter Rundfunksender.**

(30) Priorität: **20.11.86 CH 4660/86**

(43) Veröffentlichungstag der Anmeldung:
**22.06.88 Patentblatt 88/25**

(45) Bekanntmachung des Hinweises auf die
Patenterteilung:
**08.05.91 Patentblatt 91/19**

(84) Benannte Vertragsstaaten:
**CH DE ES FR GB LI NL**

(56) Entgegenhaltungen:
**EP-A- 0 025 234**
**GB-A- 2 060 297**
**GB-A- 2 117 589**
**GB-A- 2 150 378**

**BROWN & BOVERI REVIEW, Band 72, Nr. 5,
Mai 1985, Seiten 235-240, Baden, CH; W.
SCHMINKE: "High-power pulse step modulator for 500 kW short-wave and 600 kW
medium-wave transmitters"**

(73) Patentinhaber: **BBC Brown Boveri Aktiengesellschaft**

**CH-5401 Baden(CH)**

(72) Erfinder: **Kyrian, Bohumil
Ursprung 293
CH-5224 Unterbözberg(CH)**
Erfinder: **Tschol, Wilhelm
Hagenbüchlerstrasse 1
CH-5442 Fislisbach(DE)**

## Beschreibung

### Technisches Gebiet

Die Erfindung bezieht sich auf das Gebiet der Rundfunktechnik. Sie betrifft insbesondere amplitudenmodulierte Rundfunksender (AM-Rundfunksender) mit
- einer HF-Endstufe, welche mit mindestens einer Endstufenröhre bestückt ist;
- einem Hauptmodulator in Form eines Schaltverstärkers, welcher eine nach Massgabe eines NF-Eingangssignals modulierte Anodenspannung an die Endstufenröhre abgibt; und
- einem Hochfrequenzkreis mit einer Trägerfrequenzquelle zur Erzeugung eines Trägersignals und einer nachgeschalteten Treiberstufe, welche das Trägersignal verstärkt und auf ein Steuergitter der Endstufenröhre gibt.

### Stand der Technik

Bei amplitudenmodulierten Hochleistungs-Rundfunksendern, z.B. Kurz- oder Mittelwellensendern von mehreren 100 kW Sendeleistung spielt für die Betriebskosten der erreichbare Wirkungsgrad eine grosse Rolle. Für den Wirkungsgrad hat insbesondere der Aufbau und die Wirkungsweise des verwendeten Modulators eine entscheidende Bedeutung.

Man ist daher in jüngster Zeit dazu übergegangen, den bisher üblichen, mit zwei Hochleistungsröhren bestückten Gegentakt-B-Modulator durch einen Halbleiter-bestückten Schaltverstärker zu ersetzen, der entweder mit Pulsdauermodulation (PDM) arbeitet (siehe z.B. EP-B- 0 025 234) oder als sogenannter Pulsstufenmodulator (PSM) aufgebaut ist (siehe z.B. Brown Boveri Technik 5 (1985), S. 235-240).

In beiden Fällen wird die für die Modulation notwendige Leistungsverstärkung des NF-Eingangssignals nicht länger mit einem linearen Verstärker durchgeführt, sondern durch ein zeitlich gesteuertes Ein- und Ausschalten von Schaltstufen mit einer gleichbleibenden Ausgangsspannung. Das verstärkte Analogsignal wird dann mit einem am Ausgang des Schaltverstärkers liegenden Tiefpassfilter zurückgewonnen.

Beim PDM-Modulator kann aufgrund der endlichen Schaltzeiten der verwendeten Schaltelemente (z.B. Thyristoren) eine minimale Pulslänge der längenmodulierten Impulse nicht unterschritten werden. Dies hat zur Folge, dass bei an sich 100 %iger Modulation (m = 1) in einem Modulationstal, d.h. im Minimum des NF-Eingangssignals, der erforderliche Nullwert der HF-Ausgangsleistung nicht erreicht werden kann, weil der Schaltverstärker eine nicht unterschreitbare minimale Modulationsleistung an die HF-Endstufe abgibt. Eine 100 %ige Durchmodulation kann daher bei dieser Modulatorart nicht erzielt werden.

Die gleichen Ueberlegungen treffen auch für den PSM-Modulator zu, weil hier neben der groben treppenstufenartigen Approximation des gewünschten Ausgangsspannungsverlaufs durch die (z.B. 32) Schaltstufen noch eine Feinapproximation mit Hilfe einer überlagerten Pulsdauermodulation vorgenommen wird.

### Darstellung der Erfindung

Aufgabe der vorliegenden Erfindung ist es nun, einen amplitudenmodulierten Rundfunksender zu schaffen, der die mit einem als Schaltverstärker ausgebildeten Modulator erreichbaren Vorteile aufweist und zugleich zu 100 % durchmodulierbar ist.

Die Aufgabe wird bei einem AM-Rundfunksender der eingangs genannten Art dadurch gelöst, dass zur Verwirklichung einer bis zu 100 %igen Modulation auch in den Modulationstälern Mittel vorgesehen sind, mit denen über eine zusätzliche Steuerung des Trägersignals im Hochfrequenzkreis nach Massgabe des NF-Eingangssignals in einem Modulationstal der Nullwert der von der HF-Endstufe abgegebenen HF-Ausgangsspannung stufenlos erreicht werden kann.

Der Kern der Erfindung besteht also darin, zusätzlich zur bekannten Modulation der Anodenspannung für die Endstufenröhre in Modulationstälern bei näherungsweise 100 %iger Modulation auch noch das Trägersignal zu modulieren, um so über das Steuergitter der Endstufenröhre den Nullwert der HF-Ausgangsspannung stufenlos einzustellen.

Vorzugsweise wird diese zusätzliche Modulation des Trägersignals mit einem Zusatzmodulator durchgeführt, der im Hochfrequenzkreis direkt hinter der Trägerfrequenzquelle angeordnet ist.

Das für die Steuerung des Zusatzmodulators notwendige NF-Eingangssignal wird dabei insbesondere direkt am Eingang des Hauptmodulators abgegriffen und über eine Verzögerungsschaltung auf·den Zusatzmodulator gegeben, welche Verzögerungsschaltung die Signaldurchlaufzeit im Hauptmodulator ausgleicht.

Besonders vorteilhaft ist es weiterhin, zwischen der Verzögerungsschaltung und dem Zusatzmodulator eine Korrekturschaltung anzuordnen, welche insbesondere Nichtlinearitäten der HF-Endstufe und des Zusatzmodulators ausgleicht und für die zusätzliche Modulation des Trägersignals im Zusatzmodulator einen Einsatzpunkt vorgibt, von dem ab diese Modulation einsetzt.

Diese und weitere Ausführungsbeispiele ergeben sich aus den Unteransprüchen.

Kurze Beschreibung der Zeichnungen

Die Erfindung soll nachfolgend anhand von Ausführungsbeispielen im Zusammenhang mit der Zeichnung beschrieben und näher erläutert werden. Es zeigen:

Fig. 1     den prinzipiellen Aufbau eines bekannten PSM-Modulators;

Fig. 2     die Ausgangsspannung eines Modulators nach Fig. 1 mit treppenstufenartiger Approximation eines beispielhaften Signalverlaufs;

Fig. 3     ein Schema der Pulslängenmodulation in einem Schaltverstärker,

Fig. 4     eine beispielhafte modulierte HF-Ausgangsspannung mit Modulationstal;

Fig. 5     im Blockschaltbild ein bevorzugtes Ausführungsbeispiel für den erfindungsgemässen Rundfunksender;

Fig. 6     im Detailschaltbild eine erprobte Ausführungsform des Zusatzmodulators und der Korrekturschaltung gemäss Fig. 5; und

Fig. 7     im Detailschaltbild eine erprobte Ausführungsform der Verzögerungsschaltung nach Fig. 5.

Wege zur Ausführung der Erfindung

Die nachfolgenden Erläuterungen gehen, ohne Beschränkung der Allgemeinheit, aus vom Beispiel eines Rundfunksenders mit PSM-Modulator.

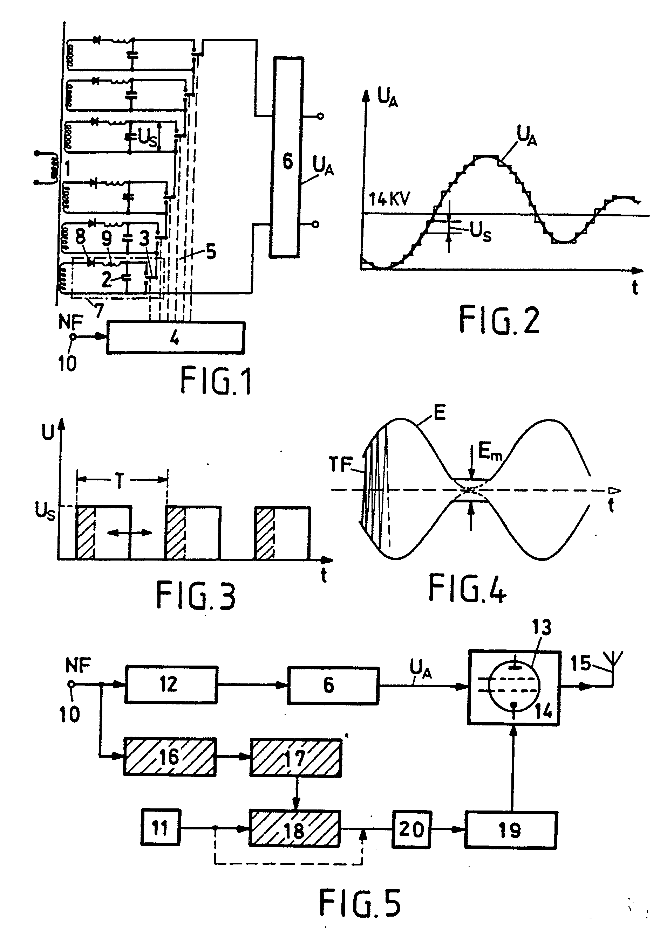

Das Prinzipschaltbild eines solchen PSM-Modualtors, wie er aus der eingangs genannten Druckschrift Brown Boveri Technik bekannt ist, ist in der Fig. 1 wiedergegeben. Zentraler Teil des Modulators ist ein aus einer Mehrzahl gleichartiger Schaltstufen 7 bestehender Schaltverstärker.

Jede Schaltstufe 7 hat eine näherungsweise konstante Ausgangsspannung $U_S$, welche die Höhe der Treppenstufen bei der Approximation eines stetigen Signalverlaufs bestimmt (Fig. 2). Zur Erzeugung dieser Ausgangsspannung $U_S$ ist jede Schaltstufe 7 an eine eigene Sekundärwicklung eines Netztransformators 1 angeschlossen, der primärseitig z.B. an einem Mittelspannungsnetz (3 ... 24 kV) betrieben wird.

Die Wechselspannung jeder Sekundärspule wird in jeder Schaltstufe 7 mittels eines Gleichrichters 8 gleichgerichtet und durch eine Kombination aus Glättungsdrossel 9 und Kondensatorbank 2 geglättet. Durch entsprechende Umschalter 3 an ihrem Ausgang können die Schaltstufen 7 sukzessive in Serie geschaltet oder aus der Serie herausgeschaltet werden.

Die Steuerung der Umschalter 3 nach Massgabe eines an einem NF-Eingang 10 anliegenden NF-Eingangssignals geschieht durch eine Schaltstufen-Steuerung 4 über potentialmässig trennende Lichtleiter 5.

Die summierten Ausgangsspannungen $U_S$ der in Serie geschalteten Schaltstufen 7 werden einem Tiefpassfilter 6 zugeleitet, durch welches das stetige Analogsignal in verstärkter Form wiedergewonnen wird. Die treppenstufenartige Spannung vor und die geglättete Ausgangsspannung $U_A$ hinter dem Tiefpassfilter 6 sind zusammen in Fig. 2 in einem beispielhaften Kurvenzug dargestellt. Die Ausgangsspannung $U_A$ schwankt hier um einen Mittelwert von 14 kV.

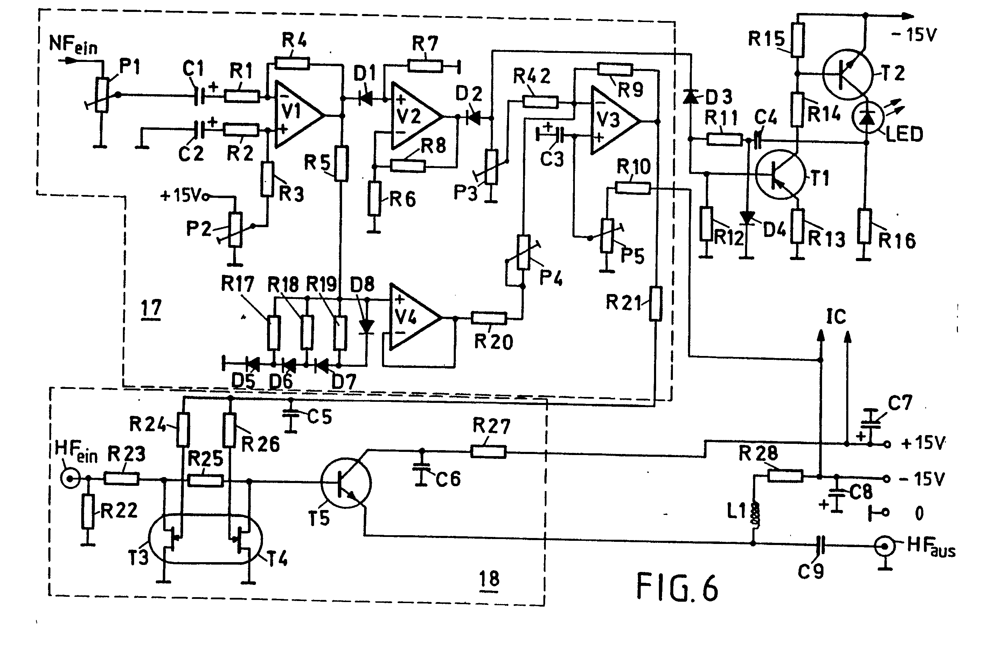

In einem Rundfunksender bekannter Art, dessen Blockschaltbild aus Fig. 5 gewonnen werden kann, wenn man die dort schraffiert eingezeichneten Funktionsblöcke weglässt, ist der Schaltverstärker nach Fig. 1 als Hauptmodulator 12 mit dem nachgeschalteten Tiefpassfilter 6 eingesetzt. Die Ausgangsspannung $U_A$ dient als modulierte Anodenspannung für eine in der folgenden HF-Endstufe 14 eingesetzte Endstufenröhre 13, meist eine Hochleistungstetrode.

Die Trägerfrequenz, deren Amplitude mit dem NF-Eingangssignal moduliert werden soll, stammt aus einer Trägerfrequenzquelle 11, einem Oszillator oder Frequenz-Synthesizer. Das Trägersignal aus der Trägerfrequenzquelle 11 wird (über den gestrichelt eingezeichneten Pfad laufend) in einem Vortreiber 20 und einer HF-Treiberstufe 19 verstärkt und dann auf ein Steuergitter der Endstufenröhre 13 in der HF-Endstufe 14 gegeben.

Der Vortreiber 20 ist meist ein breitbandiger Transistorverstärker, die HF-Treiberstufe häufig mit einer Treiberröhre bestückt. Zusammen mit der Trägerfrequenzquelle 11 und der HF-Endstufe 14 bilden sie einen Hochfrequenzkreis, dessen näherer Aufbau z.B. aus der Druckschrift Brown Boveri Mitt. 5/6 (1983), S. 235 - 240 entnommen werden kann.

Wie bereits erwähnt, zwingt die relativ geringe Zahl der Schaltstufen im Schaltverstärker (z.B. 32) dazu, eine Feinapproximation des stetigen Signals durch zusätzliche Pulslängenmodulation vorzusehen, um einen glatteren Kurvenverlauf zu erreichen. Wenigstens eine der Schaltstufen in der Serienschaltung gibt daher die in Fig. 3 gezeigten Pulse mit der Periodendauer T und variabler Pulslänge (angedeutet durch den Doppelpfeil) ab. Bei diesem Pulslängenmodulations-Betrieb kann wegen der endlichen Schaltzeiten der verwendeten Schaltelemente die schraffierte eingezeichnete Mindestpulslänge nicht unterschritten werden.

Dies bedeutet, dass, anders als in dem in Fig. 2 dargestellten, idealisierten Fall, bei 100 %iger Modulation in einem Modulationstal der Wert $U_A$ = 0 nicht stetig erreicht werden kann. Auf der Ausgangsseite des Senders, an der Antenne 15, steht damit ein Signal gemäss Fig. 4 an, bei welchem die Trägerfrequenz TF eine Einhüllende E aufweist, die im Minimum nicht der (gestrichelt eingezeichneten) Kurve für 100 %ige Modulation folgt, sondern lediglich einen endlichen Minimalwert $E_m$ annimmt. Da ein solcher Kurvenverlauf aber gleichbedeutend mit zusätzlichen Verzerrungen ist, musste man bisher bei Sendern nach dem Stand der Technik auf eine 100 %ige Durchmodulation verzichten und konnte nur soweit modulieren, bis jeweils in den Modulationstälern der Minimalwert $E_m$ der Einhüllenden erreicht war.

Um den Hauptmodulator 12 in Form des Schaltverstärkers mit seinen ganzen Vorteilen unverändert beibehalten zu können und trotzdem eine stetige 100 %ige Durchmodulation zu ermöglichen, wird nach der Erfindung an den kritischen Stellen der Modulationstäler, wenn der Minimalwert $E_m$ der Einhüllenden erreicht wird, zusätzlich das Trägersignal im Hochfrequenzkreis moduliert, d.h. stark abgesenkt. Auf diese Weise kann über das Steuergitter der Endstufenröhre 13 das HF-Ausgangssignal im Modulationstal weiter reduziert werden, obwohl die Anodenspannung $U_A$ auf ihrem Minimalwert konstant bleibt. Die kombinierte Modulation über die Anodenspannung und das Trägersignal erlaubt so eine 100 %ige Modulation ohne irgendwelche Nachteile.

Für die zusätzliche Modulation des Trägersignals ist bei dem bevorzugten Ausführungsbeispiel der Erfindung gemäss Fig. 5 in den Hochfrequenzkreis direkt hinter der Trägerfreqeuenzquelle 11 ein Zusatzmodulator 18 eingefügt (die gestrichelte Leitung hat in diesem Fall keine Bedeutung).

Das für die Steuerung des Zusatzmodulators 18 benötigte NF-Signal wird direkt am Eingang des Hauptmodulators 12 abgegriffen, also noch nach den eventuell am NF-Eingang 10 vorhandenen Eingangsfiltern. Da der Hauptmodulator 12 eine relativ grosse Signaldurchlaufzeit hat, die beiden Modulationen aber zeitlich aufeinander abgestimmt vorgenommen werden müssen, muss vor dem Zusatzmodulator 18 zunächst eine Verzögerungsschaltung 16 eingesetzt werden, welche die durch den Hauptmodulator 12 verursachte Signaldurchlaufzeit, insbesondere bei höheren Modulationsfrequenzen, ausgleicht.

Neben der Verzögerung in der Verzögerungsschaltung 16 muss das NF-Signal in einer Korrekturschaltung 17 aus den folgenden Gründen vorkorrigiert werden:

- Nichtlinearität der HF-Endstufe 14
- Nichtlinearität des Zusatzmodulators 18
- Einsatzpunkt der Zusatzmodulation erst im Bereich hoher Modulation

- Minimaler Einfluss auf $I_{g1}$ der Endstufenröhre 13
- Keine zusätzlichen Nebenausstrahlungen im HF-Spektrum

Die Detailschaltbilder von erprobten Ausführungsformen des Zusatzmodulators 18 und der Korrekturschaltung 17 sind in Fig. 6 dargestellt.

Der eigentliche Zusatzmodulator 18 besteht aus einem zweistufigen steuerbaren Abschwächer mit dem Doppel-Feldeffekttransistor T3, T4, gefolgt von einem Impedanzwandler mit dem Transistor T5, um eine undefinierbare Belastung des Abschwächers durch den nachfolgenden Vortreiber 20 zu vermeiden.

Die Korrekturschaltung 17 ist als nichtlinearer Verstärker mit den Operationsverstärkern V1 bis V4 aufgebaut. Wegen der o.g. Gründe werden für die Zusatzmodulation des Trägersignals nur relativ schmale, negative Spitzen gebraucht, jedoch ohne irgendwelche unstetigen Uebergänge.

Unter der Voraussetzung eines sinusförmigen Modulationssignals (siehe z.B. Fig. 4) wird der obere Teil der Sinuswelle stark durch den nichtlinearen Widerstand der Dioden D5 bis D8 komprimiert.

Die Form der negativen Spitzen kann durch eine Addition noch schmalerer Sinusspitzen beeinflusst werden, die durch die Diode D1, D2 und den Operationsverstärker V2 gewonnen werden und deren Amplitude mit dem Potentiometer P3 eingestellt werden kann, um eine Verbesserung des Klirrfaktors bei 100 %iger Moulation zu erreichen.

Die Transistoren T1 und T2 und die LED bilden eine Anzeigeschaltung. Die LED leuchtet beim Erreichen der 100 %igen Modulation auf, angesteuert bei jeder Modulationsspitze von einem durch die Transistoren T1 und T2 gebildeten Monoflop mit einer ausreichenden Einschaltdauer. Diese Anzeigeschaltung dient hauptsächlich als Einstellhilfe.

Mit dem Potentiometer P1 wird der NF-Eingangspegel eingestellt und mit dem Potentiometer P2 der gewünschten Einsatzpunkt eingestellt. Die Anpassung an die Modulationskennlinie der Transistoren T3, T4 und damit die gewünschte Form der Einhüllenden wird dann mit den Potentiometern P4 und P5 erreicht.

Der Zusatzmodulator 18 hat einen Frequenzbereich bis zu 30 MHz.

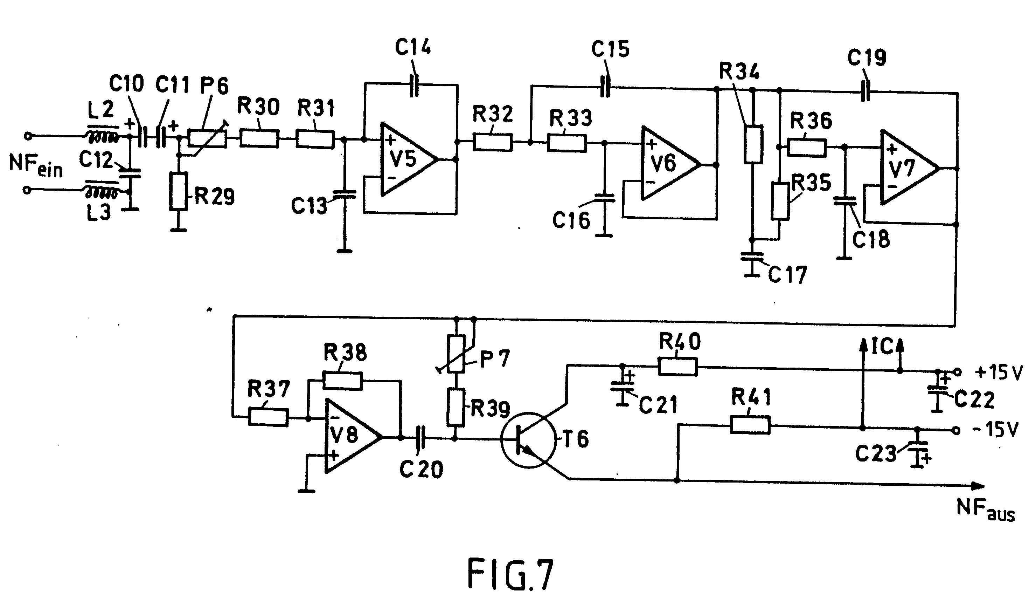

Das Detailschaltbild eines erprobten Ausführungsbeispiels für die Verzögerungsschaltung 16 ist in Fig. 7 wiedergegeben. Da eine klassische Verzögerungsleitung für die erforderlichen Laufzeiten und den NF-Bereich zu aufwendig ist, wird die Verzögerungsschaltung der Fig. 7 als dreistufiges aktives Tiefpassfilter, kombiniert mit einem einstellbaren Allpassfilter, aufgebaut.

Die 3 Stufen des Tiefpassfilters werden mittels der Operationsverstärker V5 bis V7 realisiert. Mit dem Potentiometer P6 kann der Amplitudengang bei höheren Frequenzen nach Bedarf korrigiert werden, mit dem Potentiometer P7 wird die Koinzidenz zwischen Haupt- und Zusatzmodulator bei etwa 4 kHz eingestellt.

Mit der Verzögerungsschaltung nach Fig. 7 wird die gewünschte Verzögerung im Frequenzbereich von 50 Hz bis 5 kHz erreicht.

Für die Operationsverstärker V1, ..., V8, die Transistoren T1, ..., T6, die Dioden D1, ..., D8, die Widerstände R1, ..., R42, die Kondensatoren C1, ..., C23 und die Potentiometer P1, ..., P7 der Schaltungen aus Fig. 6 und 7 können handelsübliche Bauelemente geeigneter Dimensionierung eingesetzt werden.

Insgesamt ergibt sich mit der Erfindung ein AM-Rundfunksender, der die Vorteile der Modulation mit einem Schaltverstärker aufweist und zugleich kontinuierlich bis zu 100 % durchmoduliert werden kann.

## Ansprüche

1. Amplitudenmodulierter Rundfunksender mit
   (a) einer HF-Endstufe (14), welche mit mindestens einer Endstufenröhre (20) bestückt ist;
   (b) einem Hauptmodulator (12) in Form eines Schaltverstärkers, welcher eine nach Massgabe eines HF-Eingangssignals modulierte Anodenspannung an die Endstufenröhre (13) abgibt; und
   (c) einem Hochfrequenzkreis mit einer Trägerfrequenzquelle (11) zur Erzeugung eines Trägersignals und einer nachgeschalteten HF-Treiberstufe (19), welche das Trägersignal verstärkt und auf ein Steuergitter der Endstufenröhre (13) gibt;
   dadurch gekennzeichnet, dass zur Verwirklichung einer bis zu 100 %igen Modulation auch in den Modulationstälern Mittel vorgesehen sind, mit denen über eine zusätzliche Steuerung des Trägersignals im Hochfrequenzkreis nach Massgabe des NF-Eingangssignals in Modulationstal der Nullwert der von der HF-Endstufe (14) abgegebenen HF-Ausgangsspannung stufenlos erreicht werden kann.

2. Amplitudenmodulierter Rundfunksender nach Anspruch 1, dadurch gekennzeichnet, dass die Mittel im wesentlichen einen in den Hochfrequenzkreis eingefügten Zusatzmodulator (18) umfassen.

3. Amplitudenmodulierter Rundfunksender nach Anspruch 2, dadurch gekennzeichnet, dass der Zusatzmodulator (18) direkt hinter der Trägerfrequenzquelle (11) angeordnet ist.

4. Amplitudenmodulierter Rundfunksender nach Anspruch 2, dadurch gekennzeichnet, dass das NF-Eingangssignal zur Steuerung des Zusatzmodulators (18) über eine Verzögerungsschaltung (16) auf den Zustzmodulator (18) gegeben wird, welche Verzögerungsschaltung (16) die Signaldurchlaufzeit im Hauptmodulator (12) ausgleicht.

5. Amplitudenmodulierter Rundfunksender nach Anspruch 4, dadurch gekennzeichnet, dass das NF-Eingangssignal für den Zusatzmodulator (18) direkt am Eingang des Hauptmodulators (12) abgegriffen wird.

6. Amplitudenmodulierter Rundfunksender nach Anspruch 4, dadurch gekennzeichnet, dass zwischen der Verzögerungsschaltung (16) und dem Zusatzmodulator (18) eine Korrekturschaltung (17) angeordnet ist, welche insbesondere Nichtlineratiäten der HF-Endstufe (14) und des Zusatzmodulators (18) ausgleicht und für die zusätzliche Modulation des Trägersignals im Zusatzmodulator (18) einen Einsatzpunkt vorgibt, von dem ab diese Modulation einsetzt.

7. Amplitudenmodulierter Rundfunksender nach Anspruch 2, dadurch gekennzeichnet, dass der Zusatzmodulator (18) aufgebaut ist als zweistufiger, steuerbarer Abschwächer mit einem Doppel-Feldeffekttransistor (T3, T4) und einem nachgeschalteten Impedanzwandler.

8. Amplitudenmodulierter Rundfunksender nach Anspruch 4, dadurch gekennzeichnet, dass die Verzögerungsschaltung (18) aufgebaut ist als Kombination aus einem 3-stufigen aktiven Tiefpassfilter und einem einstellbaren Allpassfilter.

9. Amplitudenmodulierter Rundfunksender nach Anspruch 6, dadurch gekennzeichnet, dass die Korrekturschaltung (17) als nichtlinearer Verstärker aufgebaut ist, der aus dem NF-Eingangssignal im wesentlichen die schmalen, negativen Spitzen herausgreift, formt und an den Zusatzmodulator (18) weiterleitet.

## Claims

1. Amplitude modulated broadcast transmitter having
   a) an RF output stage (14), which is equipped with at least one output stage tube (20);

b) a main modulator (12) in the form of a switching amplifier, which outputs an anode voltage, modulated as determined by an LF input signal, to the output stage tube (13); and

c) a radio frequency circuit with a carrier frequency source (11) for generating a carrier signal and a subsequent RF driver stage (19) which amplifies the carrier signal and passes it to a control grid of the output stage tube (13);

wherein, in order to realize up to 100 % modulation, even at the modulation minima, means are provided by means of which the zero value of the RF output voltage output by the RF output stage (14) can be continuously achieved via an additional control of the carrier signal in the radio frequency circuit as determined by the LF input signal at a modulation minimum.

2. Amplitude modulated broadcast transmitter as claimed in claim 1, wherein the means essentially comprise an additional modulator (18) inserted into the radio frequency circuit.

3. Amplitude modulated broadcast transmitter as claimed in claim 2, wherein the additional modulator (18) is arranged immediately behind the carrier frequency source (11).

4. Amplitude modulated broadcast transmitter as claimed in claim 2, wherein the LF input signal, for controlling the additional modulator (18), is applied to the additional modulator (18) via a delay circuit (16) which delay circuit (16) compensates for the signal transit time in the main modulator (12).

5. Amplitude modulated broadcast transmitter as claimed in claim 4, wherein the LF input signal for the additional modulator (18) is picked up directly at the input of the main modulator (12).

6. Amplitude modulated broadcast transmitter as claimed in claim 4, wherein, between the delay circuit (16) and the additional modulator (18), a correction circuit (17) is arranged which, in particular, compensates for nonlinearities of the RF output stage (14) and of the additional modulator (18) and predetermines a starting point for the additional modulation of the carrier signal in the additional modulator (18), from which this modulation starts.

7. Amplitude modulated broadcast transmitter as claimed in claim 2, wherein the additional modulator (18) is constructed as two-stage controllable attenuator with a dual field effect transistor (T3, T4) and a subsequent impedance converter.

8. Amplitude modulated broadcast transmitter as claimed in claim 4, wherein the delay circuit (18) is constructed as combination of a 3-stage active low-pass filter and an adjustable all-pass filter.

9. Amplitude modulated broadcast transmitter as claimed in claim 6, wherein a correction circuit (17) is constructed as nonlinear amplifier which essentially picks from the LF input signal the narrow negative peaks which it shapes and forwards to the additional modulator (18).

**Revendications**

1. Emetteur de radio à modulation d'amplitude comportant:
   - un étage final HF, qui est pourvu d'au moins un tube de puissance (20);
   - un modulateur principal (12) ayant la forme d'un amplificateur de commutation, qui fournit au tube de puissance (13), une tension d'anode modulée en proportion d'un signal d'entrée BF, et
   - un circuit de haute fréquence avec une source de fréquence porteuse (11) pour produire un signal porteur et, en aval, un étage d'attaque HF (19), qui amplifie le signal porteur et l'applique à une grille de commande du tube de puissance (13); caractérisé en ce que, pour la mise en oeuvre d'une modulation allant jusqu'à 100%, des moyens sont également prévus dans les creux de modulation, pour permettre, par une commande supplémentaire du signal porteur dans le circuit à haute fréquence en fonction du signal d'entrée BF dans un creux de modulation, d'obtenir sans à-coups la valeur zéro de la tension de sortie HF fournie par l'étage final HF (14).

2. Emetteur de radio à modulation d'amplitude suivant la revendication 1, caractérisé en ce que les moyens comprennent essentiellement un modulateur auxiliaire (18) inséré dans le circuit à haute fréquence.

3. Emetteur de radio à modulation d'amplitude suivant la revendication 2, caractérisé en ce que le modulateur auxiliaire (18) est disposé immédiatement en aval de la source de fréquence porteuse (11).

4. Emetteur de radio à modulation d'amplitude suivant la revendication 2, caractérisé en ce que le signal d'entrée BF est fourni, pour le pilotage du modulateur secondaire (18), par l'intermédiaire d'un circuit à retard (16), au modulateur auxiliaire (18), le circuit à retard (16) égalisant le temps de parcours du signal dans le modulateur principal (12).

5. Emetteur de radio à modulation d'amplitude suivant la revendication 4, caractérisé en ce que le signal d'entrée BF pour le modulateur auxiliaire (18) est prélevé directement à la sortie du modulateur principal (12).

6. Emetteur de radio à modulation d'amplitude suivant la revendication 4, caractérisé en ce qu'entre le circuit à retard (16) et le modulateur auxiliaire (18) est installé un circuit correcteur (17), qui égalise en particulier les non-linéarités de l'étage final HF (14) et du modulateur auxiliaire (18) et prédéfinit pour la modulation supplémentaire du signal porteur dans le modulateur auxiliaire (18), un point zéro à partir duquel débute cette modulation.

7. Emetteur de radio à modulation d'amplitude suivant la revendication 2, caractérisé en ce que le modulateur auxiliaire (18) a la forme d'un atténuateur pilotable à deux étages, comportant un transistor à effet de champ double (T3, T4) suivi d'un adaptateur d'impédance.

8. Emetteur de radio à modulation d'amplitude suivant la revendication 4, caractérisé en ce que le circuit à retard (18) a la forme d'une combinaison d'un filtre passe-bas actif à trois étages et d'un filtre passe-tout réglable.

9. Emetteur de radio à modulation d'amplitude suivant la revendication 6, caractérisé en ce que le circuit correcteur (17) a la forme d'un amplificateur non linéaire qui, en substance, extrait les crêtes négatives étroites du signal d'entrée BF, les façonne et les transmet au modulateur secondaire (18).

FIG.1

FIG.2

FIG.3

FIG.4

FIG.5

FIG.6

EP 0 271 703 B1

FIG.7

EP 0 271 703 B1